# EUROPEAN PATENT APPLICATION

(11) **EP 4 489 528 A1**
(43) Date of publication of application: **08.01.2025**
(21) Application number: 23183365.8
(22) Date of filing: 04.07.2023
(51) Int. Cl.: H05K 1/02, H05K 3/00, H05K 1/03

(54) **PRINTED CIRCUIT BOARD AND METHOD FOR MOUNTING AT LEAST ONE SEMICONDUCTOR CHIP DEVICE**

(71) Applicant: Infineon Technologies AG, 85579 Neubiberg (DE)
(72) Inventor: NIEßNER, Martin Richard, 80335 München (DE); HARTNER, Walter, 93077 Bad Abbach (DE); HAUBNER, Gerhard, 93049 Regensburg (DE)
(74) Representative: Infineon Patent Department

(57) **Abstract**

A printed circuit board for mounting at least one semiconductor chip device comprises a metal structure provided in a first area of the printed circuit board for soldering the semiconductor chip device onto the metal structure. The printed circuit board comprises a main surface, a layer stack comprising a first layer extending parallel to the main surface and a second layer extending parallel to the main surface. The first layer comprises a first material having a first coefficient of thermal expansion in a lateral direction and the second layer comprises a second material having a second coefficient of thermal expansion in the lateral direction such that the printed circuit board is forced by the layer stack into a curved shape at least in the first area of the printed circuit board.

## Description

### TECHNICAL FIELD

The present disclosure relates to printed circuit boards and methods for mounting at least one semiconductor chip device thereon.

### BACKGROUND

For packaging of RF semiconductor chips, package technologies such as waver level packages (WLP) or fan-out waver level packages such as embedded wafer level ball grid arrays (eWLB) are commonly used for RF semiconductor chip devices. With these package technologies, a short interconnection from the semiconductor chip device to the printed circuit board (PCB) can be achieved which reduces RF transmission losses from the semiconductor chip device to PCB. Especially in the high frequency ranges as used in RADAR or 4G, 5G, 6G, etc. this is of significant importance. With the short interconnect however, there is no material layer at the package side, which is able to buffer any coefficient of thermal expansion (CTE) mismatch between the package and the PCB. Consequently, the solder balls are exposed to the full CTE mismatch between the PCB and the main components of the semiconductor chip device which are typically silicon and a molding compound. As a result, the lifetime of solder joints between the package and the PCB may be reduced. Furthermore for the automotive market, mobile communication and consumer markets reliability requirements are constantly increasing.

It is therefore desired to have a concept which allows a reliable mounting of semiconductor chip devices on printed circuit boards.

### SUMMARY

According to a first aspect, a printed circuit board for mounting at least one semiconductor chip device thereon comprises a metal structure provided in a first area of the printed circuit board for soldering a semiconductor chip device onto the metal structure. A layer stack comprises a first layer extending parallel to a main surface of the printed circuit board and a second layer extending parallel to the main surface. The first layer comprises a first material having a first coefficient of thermal expansion in a lateral direction and the second layer comprises a second material having a second coefficient of thermal expansion in the lateral direction different from the first coefficient of thermal expansion such that the printed circuit board is forced by the layer stack into a curved shape at least in the first area of the printed circuit board.

In a second aspect, a method for mounting a semiconductor chip device comprises soldering the semiconductor chip device onto a printed circuit board. The printed circuit board comprises a metal structure provided in a first area of the printed circuit board for soldering a chip device onto the metal structure and a layer stack comprising a first layer and a second layer, wherein the first layer comprises a first material having a first coefficient of thermal expansion and the second layer comprises a second material having a second coefficient of thermal expansion different from the first coefficient of thermal expansion such that the printed circuit board is forced by the layer stack into a curved shape at least in the first area of the printed circuit board.

Those skilled in the art will recognize additional features and advantages upon reading the following detailed description, and upon viewing the accompanying drawings.

### BRIEF DESCRIPTION OF THE DRAWINGS

The present disclosure is illustrated by way of example, and not by way of limitation, in the figures of the accompanying drawings in which like reference numerals refer to similar or identical elements. The elements of the drawings are not necessarily to scale relative to each other. The features of the various illustrated examples can be combined unless they exclude each other.
Fig. 1 illustrates a RF device as an assembly of a semiconductor chip device and a printed circuit.
Fig. 2 shows the general mechanism for relaxing stress in a RF device having materials of different coefficient of thermal expansion.
Fig. 3A, 3B and 3C show an example of a layer stack and the warping when temperature is varied.
Fig. 4A, 4B and 4C show an example of a layer stack and the warping when temperature is varied.
Fig. 5 shows ranges of E-modulus and lateral coefficients of thermal expansion for layers of a layer stack according to an example.
Fig. 6 shows a relative reduction of the load on interconnect structures for various values of lateral coefficients of thermal expansion and E-modulus.
Fig. 7 shows a relative lifetime improvement for various values of lateral coefficients of thermal expansion and E-modulus.
Fig. 8 shows an example of a method for manufacturing an RF device.

### DETAILED DESCRIPTION

In the following, examples will be described which provide a new concept to reliable interconnect a semiconductor chip device with a PCB. The concept achieves a reliable interconnection for many thermal cycles and allows prolonging a product lifetime. The concept is especially suited for the mounting of RF semiconductor chip devices in wafer level packages and embedded waver level ball grid arrays as in such devices short interconnects are used to reduce RF loss. Especially in the frequency range above 40 GHz short interconnects are of significant importance.

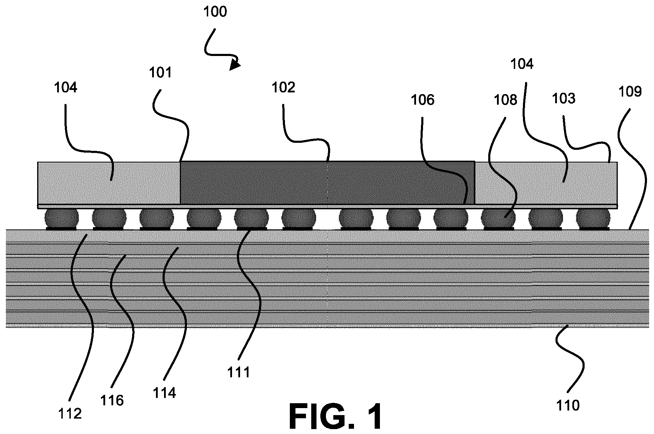

Fig. 1 shows an example of an RF device 100 with an RF semiconductor chip device 101 mounted on a PCB 110. The RF semiconductor chip device 101 includes an RF semiconductor chip 102 having an RF circuit implemented and a fan-out wafer level package 103. The RF semiconductor chip 102 includes an active chip area in which RF chip components and transistors are provided to generate RF signals or to process RF signals and other signals. Typical RF chip components include RF transistors, CMOS transistors, diodes, capacitors or inductors. The RF semiconductor chip 101 may for example be an monolithic microwave Integrated circuit (MMIC). The fan-out wafer level package 103 is an embedded wafer level ball grid array (eWLB) package including mold material portions 104 and a redistribution layer 106. The redistribution layer 106 includes metal layers which are connected to ports of the RF semiconductor chip 102.

Interconnect structures 108 are mechanically and electrically connected to the RF semiconductor chip device 101 and the PCB 110. In more detail, the interconnect structures 108 are connecting the redistribution layer 106 with metal structures 111 arranged on a mounting side 109 of the PCB 110. The metal structures 111 include solder pads for receiving the interconnect structure 108 during a soldering process to provide the mechanical and electrical connection. The metal structures 111 further include signal lines arranged on the top side of the PCB 110 or inside the PCB 110. At least some of the interconnect structures 108 and metal structures 111 are configured to transmit RF signals. In some examples, at least some of the metal structures 111 are routed on the PCB 110 in order to connect the semiconductor chip device 101 with an antenna. The interconnect structures 108 may be solder balls but other interconnect structures such as copper pillars or other structures including solder material may also be used.

The PCB 110 includes a layer stack comprising a first functional layer 112, one or more first PCB core layers 114 and one or more thin intermittent layers 116. The first PCB core layers 114 may include layers having on the top and/or bottom a metallization (such as copper) and/or preimpregnated (prepreg) layers which do not have a metallization. The first functional layer 112 is an insulating layer and is the insulating layer of the stack of layer which is arranged closer to the interconnect structures 108 than the first PCB core layers 114 and the second intermittent layers 116. The first functional layer 112 is an insulating low-RF-loss layer comprising specific low-RF-loss material to reduce RF losses of the RF signals transferred via the metal structure 111 which are close to the first functional layer 112. The one or more first PCB core layers 114 comprise for example epoxy material and fiber material and may for example be a glass-reinforced epoxy laminate material such as a FR4 material where FR stands for flame retardant. The one or more second intermittent layers 116 comprise thin copper material and/or glue material. The first PCB core layers 114 may be considered to build the core of the PCB 110 and the number of first PCB core layers may range from 1 up to 10 or even more depending on the thickness and other considerations.

During the lifetime, the RF device 100 undergoes many temperature cycles within a wide range of temperatures. For example, automotive qualification requires the product to withstand 1000, 2000 or even more temperature cycles in a temperature range from -40° C to 150° C.

It is further to be noted, that the different materials of the RF device 100 have different lateral coefficients of thermal expansion (CTEs). Unless otherwise mentioned herein, the CTE of material relates to the lateral CTE (CTE in x/y-direction) distinguished from the CTE parameter in vertical direction (CTE in z-direction). For example the semiconductor material of the RF semiconductor chip 102 may have a lateral CTE of about 3 ppm/K, the molding material provided in the molding material portions 104 may have a lateral CTE of about 6 to 10 ppm/K and the first PCB core layer 114 and second intermittent layer 116 of the PCB 110 may have a lateral CTE of 10 to 18 ppm/K.

A system having materials with different lateral CTEs encounters different length extensions or contractions when the temperature changes.

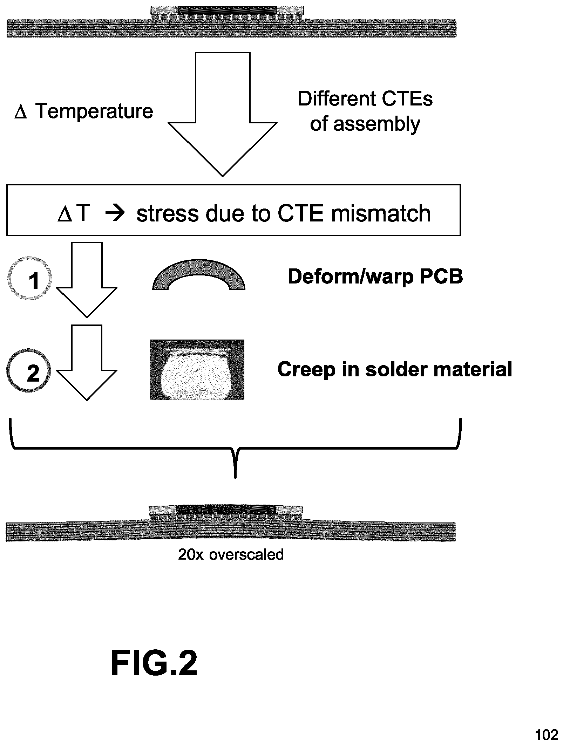

With reference to Fig. 2, general mechanisms within an assembly having a lateral CTE mismatch are shown. The temperature differences acting during a temperature cycle on the RF device 100 result in an increased stress between the RF semiconductor chip device 101 and the PCB 110. To deal with the increased stress, the assembly in general can react by a warping (deformation) and/or by a high load of the interconnect structures 108 comprising solder material in order to relax remaining stresses which cannot be evaded by the warpage (deformation). A high load on the interconnect structures 108 results in creeping within the solder material. Creeping is the damage mechanism which eventually causes end-of-life within the solder material of the interconnect structures 108.

Conventionally, the first functional layer 112 comprises PTFE-based RF laminate material which is a soft material and is able to compensate for the different CTEs in the RF device 100 and the PCB 110 due to its softness. Creeping can be avoided resulting in a long temperature cycle on board (TCoB) lifetime. However, the desire exists to replace the PTFE-based RF laminate in the first functional layer 112 with a stiffer low-RF-loss material due to higher yields of such materials and avoidance of potential legislation issues which may restrict the usage of "forever chemicals", or per- and polyfluoroalkyl substances (PFAS). Low-RF-loss material basically is a material with a loss tangent of less than 0.1. In some examples, the frequency range of operation is between 20 GHz and 200 GHz and the loss tangent may be lower than 0.1 in this frequency range.

With the first functional layer 112 being stiff and having a high CTE, creeping within the interconnect structures 108 becomes a major problem.

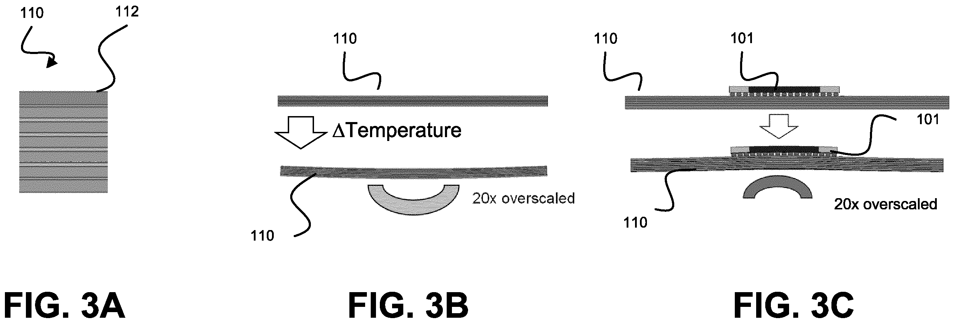

For example, considering an overall assembly including the PCB 110, the interconnect structures 108 and the RF semiconductor chip device 101. In the overall system, the PCB 110 has an overall CTE of about 10 to 18 ppm/K including a first functional layer 112 of stiff low-RF-loss material as shown in Fig. 3A and the RF semiconductor chip device 101 comprising semiconductor material has a CTE of about 3 ppm/K and the mold material has a CTE of about 6 to 10 ppm/K. With a decrease of the temperature, the assembly tends towards a convex warping of the PCB 110 when seen from the mounting side 109 (warping towards the semiconductor chip device 101), see Fig. 3C, due to the CTEs of RF semiconductor chip device 101 being much lower compared to the overall CTE of PCB 110. However, warping of the assembly can be limited due to the stiffness of the PCB 110 and package. Having in the PCB 110 a layer stack with a first functional layer 112 comprising stiff low-RF-loss material therefore worsens the situation as stiff low-RF-loss materials typically also have a higher CTE compared to the FR 4 material used in the first PCB core layers 114. In other words, the PCB 110 in standalone tends to bend concavely (when seen from the mounting side 109) for decreasing temperatures due to the CTE of the top-most first functional layer 112 being higher than CTE of the first PCB core layers 114. The reaction of the PCB 110 is therefore a warping away from the RF semiconductor chip device 101, see Fig. 3B which is the opposite to the reaction shown in Fig. 3C. Typically, the thin second intermittent layers 116 will always have a similar copper loading and therefore the relation of the first functional layer 112 to the first PCB core layers 114 is of importance for the deformation of the PCB 110. In result, due to the different warping directions, a deformation of the RF device 100 to reduce the load on the interconnect structures 108 becomes difficult and the interconnect structures 108 become highly loaded resulting in the above described creeping.

Examples described herein propose a new concept for addressing the above problem which uses a specifically designed PCB 110 that comprises a layer stack configured to force the PCB even at room temperatures (25°C) into a curved shape at least in the area where the RF semiconductor chip device 101 is mounted to the printed circuit board for unloading the interconnect structures 108. This allows using a stiff material with high CTE for the first functional layer 112 (e.g. with an E-modulus of less than 5 GPa at 25 ° C) without facing the risk of introducing creeping in the interconnect structures 108. In other words, rather than the stress being applied from external through the interconnect structures 108 onto the PCB 110 which results in high loading of the interconnect structures 108, the present concept uses a PCB 110 that is capable to deform (warp) on its own into the correct warping state which unloads the interconnect structures 108. As the force for warping is applied by the PCB 110 on its own, the interconnect structures 108 encounter significantly less mechanical stress resulting in a significant longer interconnect lifetime.

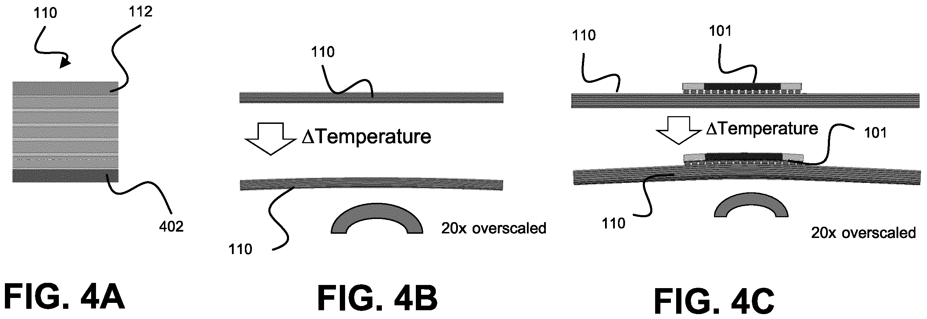

In examples, the layer stack of the PCB 110 is configured to warp in the same direction as a the PCB 110 would warp when applied to the stress from the RF semiconductor chip device 101 due to the CTE mismatch during temperature cycling (which is the warping state which unloads the interconnect structures 108). To this end, a second functional layer 402, also referred to as pre-warping layer, is introduced in the layer stack as shown in Fig. 4A. To achieve the intentional pre-warping, the material for the second functional layer 402 needs to be properly selected with sufficiently high CTE. Furthermore, the stiffness of the layer also needs to be properly selected for obtaining significant improvements of the interconnect lifetime.

For example, the layer stack of the PCB 110 may have the second functional layer 402 comprising material with a CTE that may be higher than the CTE of the first functional layer 112. The second functional layer 402 may be located farther away from the RF semiconductor chip device 101 than the first functional layer 112 in order to achieve the pre-warping. In some examples, the second functional layer 402 may be the bottom layer of the stack or located close to the bottom layer of the stack (e.g. second lowest layer from the bottom or third lowest layer from the bottom) which is most effective for pre-warping.

In the example shown in Fig. 4A, the second functional layer 402 is the bottom layer of the layer stack of the PCB 110. The second functional layer 402 can be chosen from existing materials that have a high CTE and are sufficient stiff.

Figs. 4B and 4C show the effect of the introduction of the second functional layer 402. In particular, the warping of the PCB 110 is reversed from concave (see Fig. 3B) to convex (see Fig. 4B) which is the same warping direction the overall assembly tends to warp (see Fig. 3C, 4C).

In some examples the layer stack is configured to force the printed circuit board at room temperature into a convex curvature with respect to a view direction from the mounting side 109 to the second functional layer 402. The layer stack may be configured to provide a relative curvature radius change coefficient (relative change or the radius of the PCB 110) between 0.01 Meter/Celsius and 0.1 Meter/Celsius for at least one temperature in a temperature range between 25 degree Celsius and 125 degree Celsius.

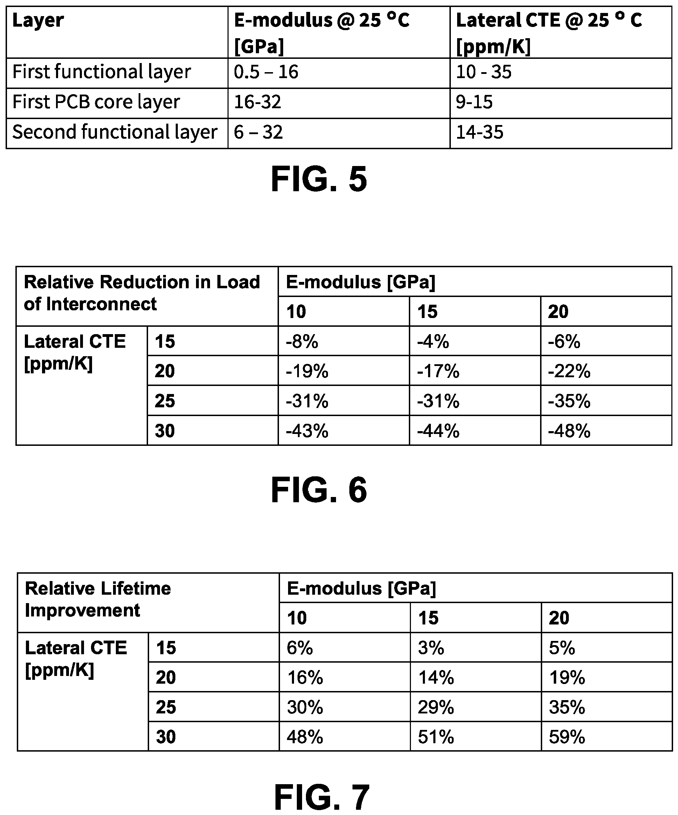

Simulations have been performed to obtain classes of material that are suitable for achieving the above described pre-warping effect. Fig. 5 shows the result of these simulations as an example of material parameters for the first functional layer 112, the first PCB core layer 114 and the second functional layer 402 that are capable of achieving the above described pre-warping of the PCB 110. All values shown in Fig. 5 are referenced to a temperature of 25 °C. The material for the first functional layer 112 can be selected to have an E-Modulus (Young's Modulus) in a range between of 0.5 and 16 GPa with a lateral CTE between 10 and 35 ppm/K. The material of the first PCB core layer can be selected to have an E-Modulus between 16 and 32 GPa and a lateral CTE between 9 and 15 ppm/K. Conventional FR4 materials typically fall within this range and can be used as first PCB core layers 114. The material of the second functional layer 402 can be selected to have an E-Modulus between 6 and 32 GPa and a lateral CTE between 14 and 35 ppm/K. The thin second intermittent layers 116 are not considered as they may always carry a similar copper loading for a similar layer stack of interest. The thickness of the first functional layer 112 and the second functional layer 402 may be in a range between 60 and 200 µm. The thickness of the one or more first PCB core layer may be in the range between 45 and 600 µm. The lateral CTE of the second functional layer 402 (bottom layer) may in some examples chosen to be higher than the lateral CTE of the first functional layer 112.

In some examples, the lateral CTE of the second functional layer 402 may be equal or lower than the lateral CTE of the first functional layer 112 with the value of the E-modulus of the second functional layer 402 being higher than the value of the E-modulus of the first functional layer 112 at 25 degree Celsius. In some examples wherein the ratio of the first coefficient of thermal expansion to the second coefficient of thermal expansion is between 0.3 and 3.5.

In some examples, a ratio of the lateral CTEs of the first functional layer 112 and the second functional layer 402 is between 0.3 and 3.5. In some examples, the E-modulus of the second functional layer 402 is higher than the E-modulus of the first functional layer 112. All values are referenced to 25°C. In some examples, the first PCB core layers 114 which are arranged between the first functional layer 112 and the second functional layer 402 material having a lateral CTE which is lower than the lateral CTE of the first functional layer 112. In some examples, second functional layer 402 has a loss tangent value which is by a factor of two higher than the loss tangent value of the first functional layer 112 at a frequency in the range between 20 GHz and 200 GHz.

Although the above described examples use only one first functional layer 112 and only one second functional layer 402, it is to be understood that also multiple first functional layers 112 or multiple second functional layers 402 may be used. The multiple first functional layers 112 and/or the multiple second functional layers 402 may include the same material or may use different materials having the properties as described in the table of Fig. 5.

To verify the improvement resulting from the pre-warping of the PCB 110, simulations have been performed. Results of these simulations are shown in Fig. 6 and Fig. 7.

Fig. 6 shows for a first functional layer 112 which has a significantly higher stiffness than PTFE-based materials the relative reduction of the load in the interconnect structures 108 for different material parameters (lateral CTE and E-Modulus) used for the second functional layer 402.

In general it can be observed that the higher the lateral CTE values of the material used in the second functional layer 402 is, the higher the relative reduction of the load is. For a material having an E-modulus of 10 GPa, a relative reduction of 43% can be achieved for a lateral CTE of 30 ppm/K compared to the relative reduction of 8% for a lateral CTE of 15 ppm/K. For a material having an E-modulus of 20 GPa, a relative reduction of 48% can be achieved for a lateral CTE of 30 ppm/K compared to the relative reduction of 6% for a lateral CTE of 15 ppm/K.

Fig. 7 shows how the relative reduction of the load on the interconnect structures 108 transfers into relative lifetime improvement. For a material having an E-modulus of 10 GPa, a relative increase of lifetime of 48% can be achieved for a lateral CTE of 30 ppm/K compared to the relative reduction of 6% for a lateral CTE of 15 ppm/K. For a material having an E-modulus of 20 GPa, a relative reduction of 59% can be achieved for a lateral CTE of 30 ppm/K compared to the relative reduction of 5% for a lateral CTE of 15 ppm/K. It can be observed that a significant lifetime improvement of over 50% can be achieved using the above described concept.

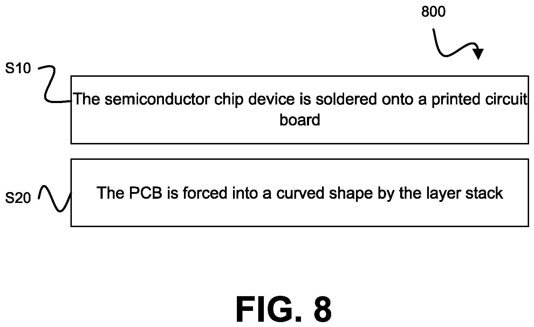

Fig. 8 shows a flow diagram for a method 800 for manufacturing the RF device 100. The method includes soldering of the semiconductor chip device onto S10. Further, the PCB is forced by the layer stack into a curved shape, S20.

Although specific examples have been illustrated and described herein, it will be appreciated by those of ordinary skill in the art that a variety of alternate and/or equivalent implementations may be substituted for the specific examples shown and described without departing from the scope of the present invention. This application is intended to cover any adaptations or variations of the specific examples discussed herein. Therefore, it is intended that this invention be limited only by the claims and the equivalents thereof

### Examples

In addition to the examples disclosed above, the following examples are disclosed herein:
Example 1: A printed circuit board for mounting at least one semiconductor chip device thereon, the printed circuit board comprising:
   a metal structure provided in a first area of the printed circuit board for soldering the semiconductor chip device onto the metal structure; and
   wherein the printed circuit board comprises a main surface;
   a layer stack comprising a first layer extending parallel to the main surface and a second layer extending parallel to the main surface,
   wherein the first layer comprises a first material having a first coefficient of thermal expansion in a lateral direction and the second layer comprises a second material having a second coefficient of thermal expansion in the lateral direction such that the printed circuit board is forced by the layer stack into a curved shape at least in the first area of the printed circuit board.
Example 2: The printed circuit board according to Example 1, wherein the layer stack forces the printed circuit board at room temperature into a convex curvature with respect to a view direction from the metal structure to the second layer, wherein the layer stack comprises a relative curvature radius change coefficient between 0.01 Meter/Celsius and 0.1 Meter/Celsius for at least one temperature in a temperature range between 25 degree Celsius and 125 degree Celsius.
Example 3: The printed circuit board according to Example 1 or 2, wherein the first layer of the layer stack is positioned closer to the metal structure than the second layer.
Example 4: The printed circuit board according to anyone of the preceding Examples, wherein a thickness of each of the first layer and the second layer is between 60 and 200 µm.
Example 5: The printed circuit board according to anyone of the preceding Examples, wherein the second coefficient of thermal expansion is higher than the first coefficient of thermal expansion.
Example 6: The printed circuit board according to anyone of the preceding Examples, wherein the second coefficient of thermal expansion is equal or lower than the first coefficient of thermal expansion and wherein the first material comprises a first elastic modulus value and wherein the second material comprises a second elastic modulus value, wherein the second elastic modulus value is higher than the first elastic modulus value at 25 degree Celsius.
Example 7: The printed circuit board according to anyone of the preceding Examples, wherein the ratio of the first coefficient of thermal expansion to the second coefficient of thermal expansion is between 0.3 and 3.5.
Example 8: The printed circuit board according to anyone of the preceding Examples, wherein the first material comprises a first elastic modulus value and wherein the second material comprises a second elastic modulus value, wherein the second elastic modulus value is higher than the first elastic modulus value at 25 degree Celsius.
Example 9: The printed circuit board according to anyone of the preceding Examples, wherein the first material comprises a first elastic modulus value which is between 0.5 and 16 GPa at 25 degree Celsius and wherein the first coefficient of thermal expansion is between 10 and 35 ppm/K at 25 degree Celsius and wherein the second material comprises a second elastic modulus value which is between 6 and 32 GPa at 25 degree Celsius and wherein the second coefficient of thermal expansion is between 14 and 35 ppm/K at 25 degree Celsius.
Example 10: The printed circuit board according to any of the preceding Examples, wherein the layer stack further comprises a plurality of third layers between the first layer and the second layer, wherein the plurality of further layers comprise a third material having a coefficient of thermal expansion in a lateral direction which is lower than the first coefficient of thermal expansion.
Example 11: The printed circuit board according to Example 10 wherein the third material comprises at least one of an epoxy material or a fiber material.
Example 12: The printed circuit board further comprising metal layers between each of the plurality of third layers.
Example 13: The printed circuit board according to Example 11 or 12 wherein the third material comprises a coefficient of thermal expansion which is lower than the second coefficient of thermal expansion .
Example 14: The printed circuit board according to anyone of the preceding Examples, wherein the first layer is formed by a low-loss-RF material, the low-loss RF material having a first loss tangent value of less than 0.1 in a frequency range between 20 GHz and 200 GHz.
Example 15: The printed circuit board according to Example 12, wherein the second layer is formed by a material having a second loss tangent value which is by a factor two higher than the first loss tangent value at a frequency in the range between 20 GHz and 200 GHz.
Example 16: The printed circuit board according to any of the preceding Examples, wherein the printed circuit board comprises an RF transmission line coupled to at least a part of the metal structure.
Example 17: A device comprising:
   an semiconductor chip device, the semiconductor chip device comprising an RF semiconductor chip;
   a printed circuit board according to any of the previous Examples,
   wherein the semiconductor chip device is soldered to the metal structure.
Example 18: The device according to Example 17, wherein the semiconductor chip device comprises a semiconductor package, the semiconductor package comprising a mold material encapsulating the semiconductor chip device, and
   wherein the mold material comprises a third coefficient of thermal expansion in a lateral direction and the semiconductor chip comprises a fourth coefficient of thermal expansion in a lateral direction, and wherein the third coefficient of thermal expansion is higher than the fourth coefficient of thermal expansion and wherein the third coefficient of thermal expansion is lower than the first coefficient of thermal expansion and is lower than the second coefficient of thermal expansion.
Example 19: The device according to Example 18, wherein the semiconductor chip device comprises a semiconductor package, wherein the mold material is lateral to the semiconductor chip device, the semiconductor package further comprising
   a redistribution layer extending along a chip area defined by the semiconductor chip and a mold area defined by the mold material,
   and wherein the semiconductor chip device is soldered to the metal structure in the mold area and is soldered to the metal structure in the chip area.
Example 20: The device according to Example 18 or 19, wherein the semiconductor chip device comprises a semiconductor package for the semiconductor chip, wherein the semiconductor chip device is configured to bend in a same bending direction as the printed circuit board when the temperature is raised from room temperature to higher temperatures.
Example 21: A method comprising:
   soldering an semiconductor chip device onto a printed circuit board, the printed circuit board comprising:
   a metal structure provided in a first area of the printed circuit board for soldering a chip device onto the metal structure; and
   a layer stack comprising a first layer and a second layer,
   wherein the first layer comprises a first material having a first coefficient of thermal expansion and the second layer comprises a second material having a second coefficient of thermal expansion different from the first coefficient of thermal expansion such that the printed circuit board is forced by the layer stack into a curved shape at least in the first area of the printed circuit board.
Example 22: The method according to Example 22, wherein the printed circuit board is forced by the layer stack into a curved shape after the semiconductor chip device is soldered onto the printed circuit board.

It should be noted that the methods and devices including its preferred embodiments as outlined in the present document may be used stand-alone or in combination with the other methods and devices disclosed in this document. In addition, the features outlined in the context of a device are also applicable to a corresponding method, and vice versa. Furthermore, all aspects of the methods and devices outlined in the present document may be arbitrarily combined. In particular, the features of the claims may be combined with one another in an arbitrary manner.

It should be noted that the description and drawings merely illustrate the principles of the proposed methods and systems. Those skilled in the art will be able to implement various arrangements that, although not explicitly described or shown herein, embody the principles of the invention and are included within its spirit and scope. Furthermore, all examples and embodiments outlined in the present document are principally intended expressly to be only for explanatory purposes to help the reader in understanding the principles of the proposed methods and systems. Furthermore, all statements herein providing principles, aspects, and embodiments of the invention, as well as specific examples thereof, are intended to encompass equivalents thereof.

## Claims

1. A printed circuit board (110) for mounting at least one semiconductor chip device (101) thereon, the printed circuit board (110) comprising:
a metal structure (111) provided in a first area of the printed circuit board (110) for soldering a semiconductor chip device (101) onto the metal structure (111); and
wherein the printed circuit board (110) comprises a main surface;
a layer stack comprising a first layer (112) extending parallel to the main surface and a second layer (402) extending parallel to the main surface,
wherein the first layer (112) comprises a first material having a first coefficient of thermal expansion in a lateral direction and the second layer (402) comprises a second material having a second coefficient of thermal expansion in the lateral direction such that the printed circuit board (110) is forced by the layer stack into a curved shape at least in the first area of the printed circuit board (110).

2. The printed circuit board (110) according to claim 1, wherein the layer stack forces the printed circuit board (110) at room temperature into a convex curvature with respect to a view direction from the metal structure (111) to the second layer (402), wherein the layer stack comprises a relative curvature radius change coefficient between 0.01 Meter/K and 0.1 Meter/K at a temperature in a temperature range between 25 degree Celsius and 125 degree Celsius.

3. The printed circuit board (110) according to anyone of the preceding claims, wherein the second coefficient of thermal expansion is higher than the first coefficient of thermal expansion.

4. The printed circuit board (110) according to anyone of the preceding claims, wherein the second coefficient of thermal expansion is equal or lower than the first coefficient of thermal expansion and wherein the first material comprises a first elastic modulus value and wherein the second material comprises a second elastic modulus value, wherein the second elastic modulus value is higher than the first elastic modulus value at 25 degree Celsius.

5. The printed circuit board (110) according to anyone of the preceding claims, wherein the ratio of the first coefficient of thermal expansion to the second coefficient of thermal expansion is between 0.3 and 3.5.

6. The printed circuit board (110) according to anyone of the preceding claims, wherein the first material comprises a first elastic modulus value and wherein the second material comprises a second elastic modulus value, wherein the second elastic modulus value is higher than the first elastic modulus value at 25 degree Celsius.

7. The printed circuit board (110) according to anyone of the preceding claims, wherein the first material comprises a first elastic modulus value which is between 0.5 and 16 GPa at 25 degree Celsius and wherein the first coefficient of thermal expansion is between 10 and 35 ppm/K at 25 degree Celsius and wherein the second material comprises a second elastic modulus value which is between 6 and 32 GPa at 25 degree Celsius and wherein the second coefficient of thermal expansion is between 14 and 35 ppm/K at 25 degree Celsius.

8. The printed circuit board (110) according to any of the preceding claims, wherein the layer stack further comprises a plurality of third layers (114, 116) between the first layer (112) and the second layer (402), wherein the plurality of third layers (114, 116) comprise a third material having a coefficient of thermal expansion in the lateral direction which is lower than the first coefficient of thermal expansion.

9. The printed circuit board (110) according to claim 8 wherein the third material comprises a coefficient of thermal expansion in a lateral direction which is lower than the second coefficient of thermal expansion.

10. The printed circuit board (110) according to anyone of the preceding claims, wherein the first layer (112) is formed by a low-loss-RF material, the low-loss RF material having a first loss tangent value of less than 0.1 in a frequency range between 20 GHz and 200 GHz.

11. The printed circuit board (110) according to claim 10, wherein the second layer (402) is formed by a material having a second loss tangent value which is by a factor two higher than the first loss tangent value at a frequency in the range between 20 GHz and 200 GHz.

12. A device (100) comprising:
an semiconductor chip device (101), the semiconductor chip device comprising an RF semiconductor chip (102);
a printed circuit board (110) according to any of the previous claims,
wherein the semiconductor chip device (101) is soldered to the metal structure (111).

13. The device (100) according to claim 12, wherein the semiconductor chip device (101) comprises a semiconductor package (103), the semiconductor package (103) comprising
a mold material (104) encapsulating the semiconductor chip device (101), and wherein the mold material (104) comprises a third coefficient of thermal expansion in a lateral direction and the semiconductor chip (102) comprises a fourth coefficient of thermal expansion in a lateral direction, and wherein the third coefficient of thermal expansion is higher than the fourth coefficient of thermal expansion and wherein the third coefficient of thermal expansion is lower than the first coefficient of thermal expansion and is lower than the second coefficient of thermal expansion.

14. The device (100) according to claim 13, wherein the semiconductor chip device (101) comprises a semiconductor package (103), wherein the mold material (104) is lateral to the semiconductor chip device (101), the semiconductor package (103) further comprising
a redistribution layer (106) extending below a chip area defined by the semiconductor chip (102) and a mold area defined by the mold material (104),
and wherein the semiconductor chip device (101) is soldered to the metal structure (111) in the mold area and is soldered to the metal structure (111) in the chip area.

15. The device according to anyone of claims 12 to 14, wherein the semiconductor chip device (101) comprises a semiconductor package (103) for the semiconductor chip (102), wherein the semiconductor chip device (101) is configured to bend in a same bending direction as the printed circuit board (110) when the temperature is raised from room temperature to higher temperatures.

16. A method for mounting a semiconductor chip device comprising:
soldering (S10) the semiconductor chip device onto a printed circuit board (110), the printed circuit board (110) comprising:
a metal structure (111) provided in a first area of the printed circuit board (110) for soldering a semiconductor chip device (101) onto the metal structure (111); and
a layer stack comprising a first layer (112) and a second layer (402),
wherein the first layer (112) comprises a first material having a first coefficient of thermal expansion and the second layer (402) comprises a second material having a second coefficient of thermal expansion different from the first coefficient of thermal expansion such that the printed circuit board (110) is forced by the layer stack into a curved shape at least in the first area of the printed circuit board (110).

17. The method according to claim 16, wherein the printed circuit board (110) is forced by the layer stack into a curved shape after the semiconductor chip device (101) is soldered onto the printed circuit board (110).
